# EUROPEAN PATENT APPLICATION

(11) **EP 4 651 636 A2**
(43) Date of publication of application: **19.11.2025**
(21) Application number: 25169702.5
(22) Date of filing: 10.04.2025
(51) Int. Cl.: H05K 1/11, H05K 1/14, H05K 3/36, H05K 1/02

(54) **POSTS HAVING MULTIPLE WIDTHS**

(30) Priority: 24.04.2024 US 202418644559
(71) Applicant: Avago Technologies International Sales Pte. Limited, Singapore 768923 (SG)
(72) Inventor: Sun, Li, San Jose, CA, 95148 (US); Chung, Ki Woong, San Jose, CA, 95120 (US); Leary, Michael, Sunnyvale, CA, 94087 (US); Choi, Chang Kyu, Fremont, CA, 94536 (US); Haney, Sarah Kay, San Jose, CA, 95112 (US); Wu, Qifeng, San Jose, CA, 94539 (US)
(74) Representative: Grünecker Patent- und Rechtsanwälte PartG mbB

(57) **Abstract**

Novel tools and techniques are provided for implementing a semiconductor package or a chip package, and more particularly methods, systems, and apparatuses are provided for implementing a semiconductor package or a chip package including at least two posts having different widths. In an embodiment, a system can include a first substrate having a first layer comprising a first post having a first width and a second layer coupled to the first layer and comprising an external surface of the first substrate and a second post having a second width connected to the first post. The first width can be less than the second width. The system can further include a solder connected to the second post and configured to connect the second post to a first connector on a second substrate.

## Description

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for implementing a semiconductor device.

### BACKGROUND

Communication devices, such as smartphones, continually undergo redesign processes to increase functionality, with the goal of the increased functionality not increasing form factor size. In fact, the goal in many cases is to either maintain form factor size or decrease form factor size while still increasing functionality.

Typically, in order to couple a circuit board to a motherboard, a solder is used to couple one or more copper posts of the circuit board to one or more corresponding connectors of the motherboard. However, as the width of copper posts decrease to enable additional functionality, the solder between the circuit board and the motherboard can be prone to cracking.

Hence, there is a need for more robust and scalable solutions for implementing a semiconductor device or system comprising one or more solders that are not prone to cracking. Thus, methods, systems, and apparatuses are provided for implementing semiconductor packages or systems comprising a first post having a first width connected to a second post having a second width.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
FIG. 1 is a cross-sectional view of an embodiment of a semiconductor device, in accordance with various embodiments;
FIG. 2 is a top view of a portion of the semiconductor device of FIG. 1 looking down from the first layer to the second layer of the first substrate, in accordance with various embodiments;
FIG. 3 is a cross-sectional view of a first post coupled to a second post which is coupled to a corresponding connector via a solder connection, in accordance with various embodiments;
FIG. 4 cross-sectional view of two first posts coupled to a single second post, in accordance with various embodiments;
FIG. 5 is a top view of a portion of another semiconductor device looking down from the first layer to the second layer of the first substrate, in accordance with various embodiments;
FIG. 6 is top view of a portion of the semiconductor device of FIG. 5, in accordance with various embodiments;
FIGS. 7A is a cross-sectional views of the portion of the semiconductor device of FIG. 6 taken along line A-A, in accordance with various embodiments;
FIGS. 7B is a cross-sectional views of the portion of the semiconductor device of FIG. 6 taken along line B-B, in accordance with various embodiments;
FIGS. 8A and 8B are top views of another portion of the semiconductor device of FIG. 5, in accordance with various embodiments;
FIGS. 9A and 9B are top views of a third portion of the semiconductor device of FIG. 5, in accordance with various embodiments;
FIGS. 10A and 10B are top views of a fourth portion of the semiconductor device of FIG. 5, in accordance with various embodiments;
FIGS. 11A and 11B are top views of a fifth portion of the semiconductor device of FIG. 5, in accordance with various embodiments;
FIG. 12 is a flow diagram of a method of manufacturing a semiconductor device, in accordance with various embodiments;
FIG. 13 is a graph showing a first creep strain increment based on a ratio of a first width of one or more first posts to a second width of one or more second posts, in accordance with various embodiments; and
FIG. 14 is a graph showing a first creep strain increment based on a ratio of a first thickness of one or more first posts to a second thickness of one or more second posts, in accordance with various embodiments.

### DETAILED DESCRIPTION OF EMBODIMENTS

Various embodiments provide tools and techniques for implementing semiconductor packages or chip packages including one or more first posts having a first width and one or more second posts having a second width are described herein.

In a first aspect, a system comprises a first substrate including a first layer comprising a first post having a first width and a second layer coupled to the first layer and comprising an outer surface of the first substrate and a second post having a second width connected to the first post. In some cases, the first width is less than the second width. The system can further include a solder connected to the second post and configured to connect the second post to a first connector on a second substrate.

In some embodiments, the first substrate is a printed circuit board and the second substrate is a motherboard. In this configuration, the solder can be configured to connect the second post of the first substrate to the first connector on the second substrate.

In some instances, the second width of the second post is about a same width as a corresponding third width of the first connector on the second substrate.

In various cases, a first ratio between the first width of the first post and the second width of the second post is less than or about equal to 0.375. In some cases, the first width of the first post is about 70 micrometers or less. In various instances, a first thickness of the first post is about a same thickness as a second thickness of the second post. In other instances, a second ratio between a first thickness of the first post and a second thickness of the second post is greater than or about equal to 1.28. In this configuration, the first thickness of the first post can be about 37 micrometers or more.

In some embodiments, the first layer further comprises an other first post coupled to the second post. In some cases, a third width of the other first post is about a same width as the first width of the first post. In other cases, a third width of the other first post is a different width than the first width of the first post. In various instances, the first width of the first post and a third width of the other first post combined are less than the second width of the second post.

In various instances, a first shape of the first post is configured as at least one of a bar shape, a bent shape, a Z shape, an S shape, an L shape, a cruciform shape, a hollow block shape, or a block shape and a second shape of the second post is a same shape as the first shape of the first post. In other instances, the second post is configured as at least one of a bar shape, a bent shape, a Z shape, an S shape, an L shape, a cruciform shape, a hollow block shape, or a block shape and the first layer further comprises an other first post coupled to the second post.

In some cases, the system can further include a third layer coupled to the first layer opposite the second layer and comprising a first interconnect connected to the first post and a die coupled to the third layer opposite the first layer and comprising a second connector connected to the first interconnect.

In another aspect, a substrate can include a first layer comprising a first post having a first width and a second layer comprising an external surface and a second post connected to the first post. The second post can have a second width. The first width can be less than the second width. The external surface of the second layer can be configured to couple to another substrate.

In various cases, a first ratio between the first width of the first post and the second width of the second post is less than or about equal to 0.375. In some cases, the first width of the first post is about 70 micrometers or less. In various instances, a first thickness of the first post is about a same thickness as a second thickness of the second post. In other instances, a second ratio between a first thickness of the first post and a second thickness of the second post is greater than or about equal to 1.28. In this configuration, the first thickness of the first post can be about 37 micrometers or more.

In another aspect, a method of forming a forming one or more posts between a first substrate and a second substrate can include forming a first layer of the first substrate comprising a first post having a first width and forming a second layer on the first layer of the first substrate comprising a second post having a second width and connected to the first post. The second layer can be an outer layer of the first substrate and the first width can be less than the second width.

The method can further include forming a solder between the second post and a connector of the second substrate to connect the second post to the connector of the second substrate.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected," "coupled," or "attached" to another element (such as coupled or connected through an electrical or communicative connection or coupled or attached through a mechanical connection or attachment), it is to be understood that the elements can be directly connected to the other element, or have intervening elements present between the elements. In contrast, when an element is referred to as being "directly connected," "directly coupled," or "directly attached" to another element, it should be understood that no intervening elements are present in the "direct" connection between the elements. However, the existence of a direct connection does not exclude other connections or contacts, in which intervening elements may be present.

When an element is referred to herein as being "disposed" or "located" in some manner relative to another element (e.g., disposed on, disposed between, disposed under, disposed adjacent to, or disposed in some other relative manner), it is to be understood that the elements can be directly disposed or located relative to the other element (e.g., disposed directly on another element), or have intervening elements present between the elements. In contrast, when an element is referred to as being "disposed directly" or "located directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Additionally, when an element is referred to herein as being a "circuit" or "die", it is commonly recognized as a building block of modern electronics. Circuits or dies are composed of various electronic components such as resistors, capacitors, inductors, diodes, transistors, and integrated circuits. In some cases, integrated circuits can be formed from one or more circuits. These electronic components are carefully selected and interconnected to create a circuit that can perform a specific task or carry out a particular function. Circuits can be as simple as a basic switch that turns a light on and off, or they can be incredibly complex, such as those found in advanced computer systems, communication devices, or medical equipment. Circuits can be categorized into different types based on their purpose or function, including amplifiers, oscillators, filters, power supplies, and logic gates, among others. Additionally, circuits can include software or firmware in addition to hardware or instead of hardware to carry out a particular function.

Additionally, various units, circuits, modules, or other components may be described as "configured to" or "adapted to" perform a task or tasks. In such contexts, "configured to" or "adapted to" is a broad recitation of structure generally meaning "having circuitry that" performs the task or tasks during operation. As such, the unit/circuit/module/component can be configured to perform the task even when the unit/circuit/module/component is not currently on. In general, the circuitry that forms the structure corresponding to "configured to" or "adapted to" may include hardware circuits and/or memory storing program instructions executable to implement the operation. The memory can include volatile memory such as static or dynamic random-access memory and/or nonvolatile memory such as optical or magnetic disk storage, flash memory, programmable read-only memories, etc. Similarly, various unit/circuit/module/component may be described as performing a task or tasks, for convenience in the description. Such descriptions should be interpreted as including the phrase "configured to" or "adapted to." Reciting a unit/circuit/component that is configured to perform one or more tasks is expressly intended not to invoke 35 U.S.C. §112, paragraph six interpretation for that unit/circuit/component.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components. Additionally, terms such as first, second, third, are merely used to distinguish elements or components from each other and are not intended to imply an order or sequence unless expressly stated otherwise.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." The term "about" used herein refers to variations from the reference value or ratio of ± 20% or less (e.g., ± 20%, ± 10%, ± 5%, etc.), inclusive of the endpoints of the range.

In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

In existing circuit boards, copper posts are typically straight and do not have multiple widths. However, as the width of copper posts decrease in order to add more functionality to a first substrate such as a circuit board, solder connections between the first substrate and another substrate such as a motherboard can be prone to cracking.

The subject technology comprises a semiconductor device or system that provides a first substrate having copper posts formed from a first post having a first width and a second post having a second width. In various cases, the first width is less than the second width. The second post can be connected to a second substrate or the like by a solder connection between the first substrate and the second substrate. By forming a copper post from a first post having a first width and a second post having a second width, several advantages are realized. For example, the force from the first post is distributed over the larger width of the second post, thereby reducing the stress or the strain on the solder connection and preventing (e.g., substantially or fully) the solder connection from cracking. Additionally, by forming a copper post from a first post having a first width and a second post having a second width, smaller copper posts can be used thereby increasing the functionality of the semiconductor device or decreasing the size of the first substrate or the second substrate.

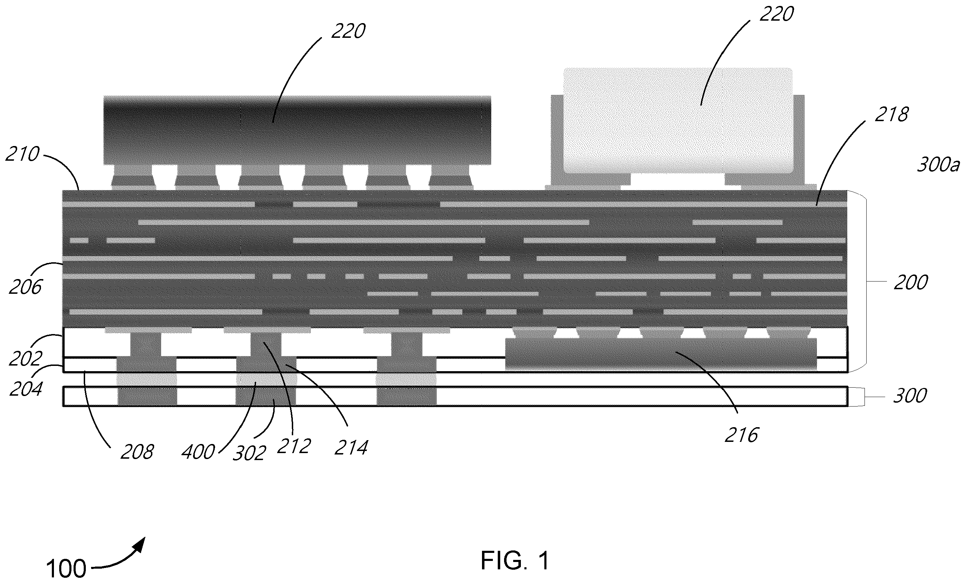

FIG. 1 is a cross-sectional view of an embodiment of a semiconductor device 100 comprising a first substrate 200 and a second (or an other) substrate 300.

In some cases, the first substrate 200 could be a circuit board (e.g., a printed circuit board or the like) or other supporting material upon which or within which elements or components of the semiconductor device 100 are fabricated or attached. The first substrate 200 can include one or more layers. The one or more layers can include, without limitation, one or more dielectric layers, one or more device or circuit layers, one or more conducting layers, one or more insulating layers, one or more redistribution layers, other layers, and/or the like. The layers may further include one or more routing layers or layers configured to provide component interconnections. The one or more layers can be formed from one or more of silicon, silicon dioxide, aluminum oxide, gallium, germanium, ceramics, organic structures, laminated organic structures, dielectric materials, conductive materials, and/or any other material or combination of materials needed to form one or more layers of the first substrate 200.

As shown in FIG. 1, the first substrate 200 can have one or more first layers 202, one or more second layers 204, one or more third layers 206, or one or more other layers (not shown). The one or more first layers 202 can be located between the one or more second layers 204 and the one or more third layers 206. In some cases, the one or more second layers 204 can have a first surface 208 and the one or more third layers 206 can have a second surface 210. The first surface 208 or the second surface 210 could be one or more external or outer surfaces (e.g., one or more surfaces of the first substrate configured to couple to the second substrate 300 or one or more dies) of the first substrate 200.

The one or more first layers 202 could be one or more first dielectric layers comprising one or more first posts 212. The one or more second layers 204 could be one or more second dielectric layers including one or more second posts 214. In various cases, the one or more first posts 212 could be embedded (e.g., fully, substantially, or partially, or the like) in the one or more first layers 202 while the one or more second posts 214 can be embedded in the one or more second layers 204. The one or more second layers 204 could be one or more external or outer layers of the first substrate 200.

In some cases, the one or more first layers 202 or the one or more second layers 204 could include one or more first dies 216 fully, substantially, or partially integrated within or coupled to the one or more first layers 202 or the one or more second layers 204. The one or more third layers 206 could be one or more routing layers comprising one or more interconnects 218. In some embodiments, one or more second dies 220 can be coupled to the second surface 210 of the one or more third layers 206.

In various instances, the one or more first posts 212 or the one or more second posts 214 can be formed from one or more conductive materials. The one or more conductive materials can include, without limitation, one or more of copper, titanium, aluminum, gold, silver, tin, nickel, lead, or a combination of metals/alloys, or may be formed of other electrically conductive material. In some cases, one or more sidewalls of the or more first posts 212 or the one or more second posts 214 can be straight or tapered.

In various instances, the one or more first posts 212 or the one or more second posts 214 can be one or more vias. Alternatively, the one or more first posts 212 can be coupled (e.g., attached or the like) or connected (e.g., electrically connected or the like) to the one or more second posts 214 to form a connection (e.g., an electrical connection or the like) between the first post 212 and the second post 214. In various cases, the one or more first posts 212 can be directly coupled or directly connected to the one or more second posts 214. In various cases, the one or more first posts 212 coupled or connected to the one or more second posts 214 can together form one or more vias.

The one or more vias may extend completely through the first substrate 200 (e.g., a "through" via) from the first surface 208 to the second surface 210, may extend through a portion of the first substrate 200 from the first surface 208 (e.g., a "blind" via), or may extend through a portion of the first substrate 200 and be completely hidden from external view (e.g., a "buried" via), and/or the like

The one or more first posts 212 or the one or more second posts 214 can perform one or more functions. For example, the one or more first posts 212 or the one or more second posts 214 can provide one or more of one or more mounting points for the first substrate 200 (e.g., a mounting point for mounting the first substrate 200 to the second substrate 300), thermal dissipation for the first substrate 200, signal blocking to block or prevent signals between components of the first substrate 200, one or more return ground paths for electric current transmitted or received through the first substrate 200, one or more power paths to transmit power to or receive power from one or more components (e.g., one or more first dies 216, one or more second dies 220, one or more components of the second substrate 300, or the like) of the semiconductor device 100, one or more signal paths to transmit signals to or receive signals from one or more components of the semiconductor device 100, or the like.

In various cases, the one or more first posts 212 can be coupled, either directly or indirectly, or connected, either directly or indirectly, to one or more interconnects 218 of the one or more third layers 206. The one or more third layers 206 can include the one or more interconnects 218 which can be configured to route one or more signals or power through the first substrate 200 from or to the one or more first dies 216 or second dies 220. In various cases, the one or more interconnects 218 can be configured to route one or more signals or power from or to the one or more first posts 212 or the one or more second posts 214 to or from the one or more first dies 216 or one or more second dies 220.

The one or more first dies 216 or one or more second dies 220 can include one or more electronic dies, electronic circuits, electronic integrated circuits (EICs), one or more photonic dies, photonic circuits, or photonic integrated circuits (PICs), passive components, or the like. The one or more first dies 216 or one or more second dies 220 can include one or more layers (not shown). The one or more layers can include, without limitation, one or more dielectric layers, one or more device or circuit layers, one or more conducting layers, one or more insulating layers, one or more redistribution layers, other layers, and/or the like. The layers may further include one or more layers configured to provide component interconnections.

In some embodiments, the one or more first dies 216 or one or more second dies 220 can include, without limitation, a processing circuit (e.g., a central processing unit, a microprocessor, or the like), a switch circuit (e.g., a switch application specific integrated circuit (ASIC) or the like), a memory circuit, a circuit configured to receive one or more optical signals, or the like.

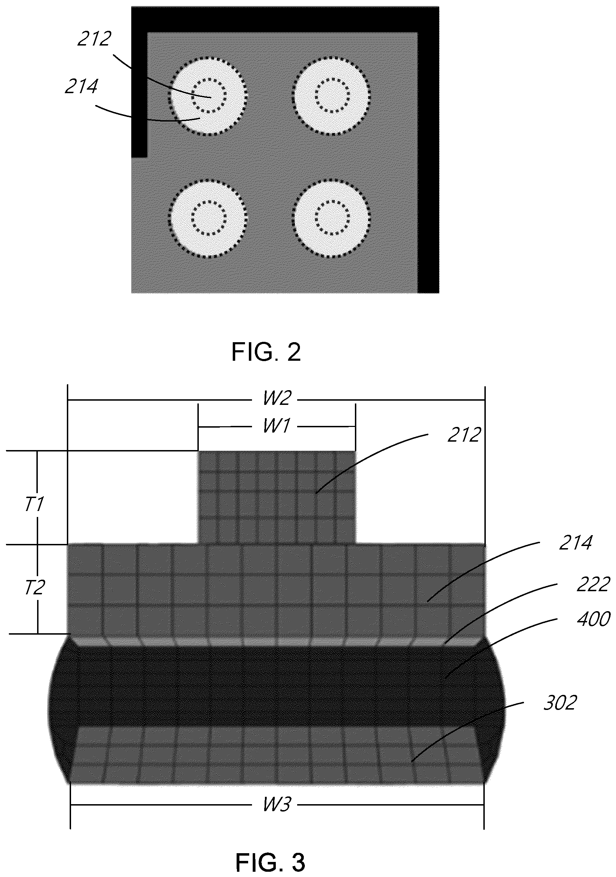

In some cases, the one or more second posts 214 can be coupled, either directly or indirectly, or connected, either directly or indirectly, to one or more connections or solders 400 (e.g., a connection configured to couple or connect the one or more second posts 214 to a corresponding connector 302 on the second substrate 300, or the like). The one or more connections 400 can include, without limitation, one or more solder connections, one or more solder welds, or other connections configured to couple the one or more second posts 214 to the one or more connections 400. In some cases, one or more optional pads (shown in FIG. 3) 222 can be coupled, either directly or indirectly, or connected, either directly or indirectly, between the one or more second posts 214 and the one or more connections 400. The one or more pads 222 can be formed on the first surface 208 of the first substrate 200. The one or more pads 222 can be one or more conductive pads formed on the first surface 208 from one or more of copper, titanium, aluminum, gold, silver, tin, nickel, lead, or a combination of metals/alloys, or may be formed of other electrically conductive material.

The one or more connections or solders 400 can then be configured to be coupled, either directly or indirectly, or connected, either directly or indirectly, to one or more connectors 302 on the second substrate 300. The second substrate 300 can include, without limitation, a motherboard of a communication device such as a phone, tablet, computer, laptop, gaming console, smartwatch or the like or other supporting material upon which or within which elements or components of the semiconductor device 100 or communication device are fabricated or attached.

The second substrate 300 can include one or more layers (not shown). The one or more layers can include, without limitation, one or more dielectric layers, one or more device or circuit layers, one or more conducting layers, one or more insulating layers, one or more redistribution layers, other layers, and/or the like. The layers may further include one or more routing layers or layers configured to provide component interconnections. The one or more layers can be formed from one or more of silicon, silicon dioxide, aluminum oxide, gallium, germanium, ceramics, organic structures, laminated organic structures, dielectric materials, conductive materials, and/or any other material or combination of materials needed to form one or more layers of the first substrate 200.

The one or more connectors 302 can include without limitation, one or more pads, one or more vias, one or more interconnects, one or more bumps, one or more pins, or other conductive elements of the second substrate 300. The one or more connectors 302 can be formed from one or more of copper, titanium, aluminum, gold, silver, tin, nickel, lead, or a combination of metals/alloys, or may be formed of other electrically conductive material, or may be coated by an organic solderability preservative OSP, or the like.

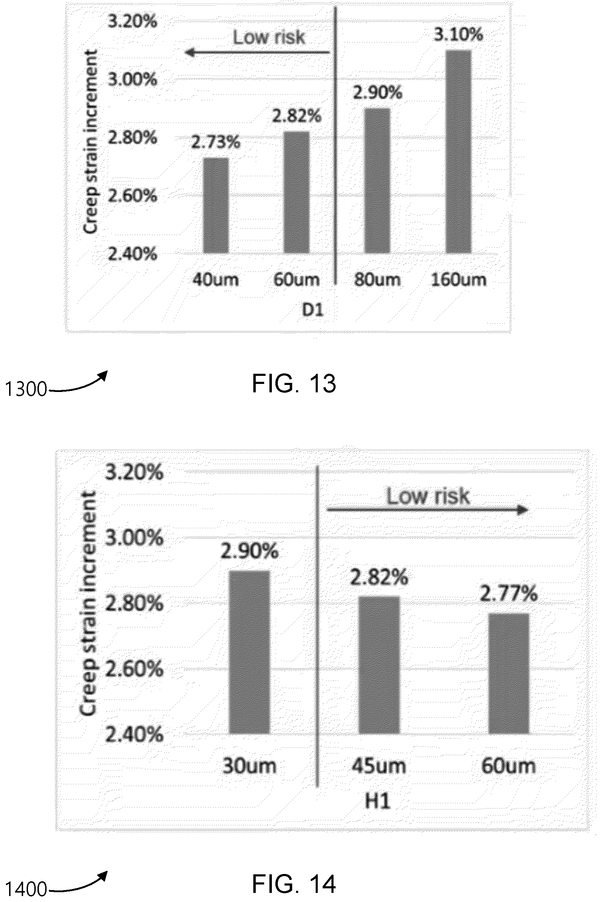

In various embodiments, as shown in FIGS. 1-3, the one or more first posts 212 can have a first width (W1), diameter, or area while the one or more second posts 214 can have a second width (W2), diameter, or area. The first width (W1), diameter, or area can be less than or smaller than the second width (W2), diameter, or area. In some instances, a first ratio (W1/W2) between the first width (W1) of the first post 212 and the second width (W2) of the second post 214 is less than or about equal to 0.375. In some cases, the first width (W1) of the first post 212 is about 70 micrometers or less while the second width (W2) of the second post 214 is about 160 micrometers or less. By having the first width (W1), diameter, or area of the first post 212 be less than the second width (W2), diameter, or area of the second post 214, the chance of the one or more connections 400 (e.g., the one or more solder connections) cracking is reduced because the force of the first post 212 is distributed over the larger second post 214. By having the first ratio (W1/W2) be less than or about equal to 0.375 or the width of the first post be about 70 micrometers or less, the strain on the one or more connections 400 and the chance of the one or more connections 400 cracking is significantly reduced as shown in the graph 1300 of FIG. 13. In a non-limiting example, the one or more connectors 400 were shown as significantly less likely to crack when the creep strain increment was 2.85% or less. Additionally, the first post 212 and the second post 214 can be smaller which increases the number of posts that can be used or the functionality within the semiconductor device 100.

Further, in various cases, as shown in FIG. 3, a third width (W3), diameter, or area of the one or more connectors 302 of the second substrate 300 can be about a same width, diameter, or area as the second width (W2), diameter, or area of the second post 214. By having the third width (W3), diameter, or area be about a same width, diameter, or area as the second width (W2), diameter, or area, the second post 214 can be more easily coupled or connected to a corresponding connector 302.

Additionally, in some instances, as shown in FIG. 3, the one or more first posts 212 can have a first thickness (T1) or height while the one or more second posts 214 can have a second thickness (T2) or height. The first thickness (T1) or height can be about the same as the second thickness (T2) or height. In some instances, the first thickness (T1) or height and the second thickness (T2) or height can be in the range of 5 micrometers to 100 micrometers or preferably about 40 micrometers. Alternatively, the first thickness (T1) or height can be greater than or larger than the second thickness (T2) or height. In some instances, a second ratio (T1/T2) between the first thickness (T1) or height of the first post 212 and the second thickness (T2) or height of the second post 214 is greater than or about equal to 1.28. In some instances, a first thickness (T1) or height can be about 45 micrometers while the second thickness (T2) or height can be about 35 micrometers. By having the first thickness (T1) or height of the first post 212 be greater than the second thickness (T2) or height of the second post 214, the chance of the one or more connections 400 (e.g., the one or more solder connections) cracking is reduced because the force of the first post 212 is distributed over a smaller thickness second post 214. By having the second ratio (T1/T2) be less than or about equal to 1.28 or the first thickness of the first post be about 37 micrometers or more, the strain on the one or more connections 400 and the chance of the one or more connections 400 cracking is significantly reduced as shown in the graph 1400 of FIG. 14. In a non-limiting example, the one or more connectors 400 were shown as significantly less likely to crack when the creep strain increment was 2.85% or less.

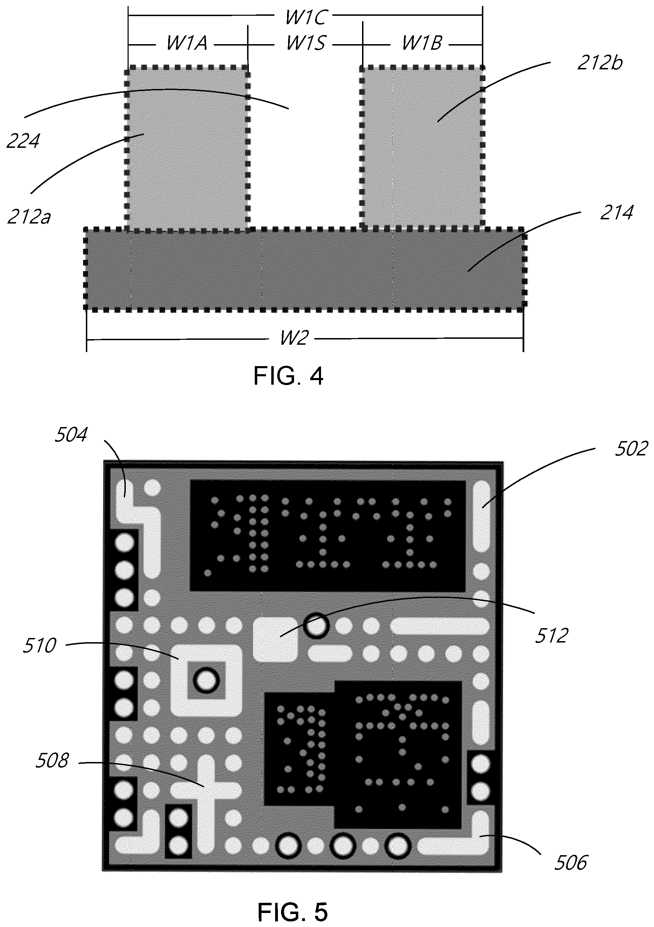

Turning to FIG. 4, in some cases, at least two first posts 212a and 212b can be coupled to one second post 214. In other words, both the first post 212a and at least one other first post 212b can be coupled to the second post 214. Having at least two first posts 212a and 212b coupled to a single second post 214 can further increase the functionality of the semiconductor device 100 while distributing the force from the at least two first posts 212a and 212b over the larger second post 214.

In some cases, as shown in FIG. 4, a first width (W1A), diameter, or area of the first post 212a can be about a same width, diameter, or area as an other first width (W1B), diameter, or area of the other first post 212b. Alternatively, the first width (W1A), diameter, or area of the first post 212a can be a different width, diameter, or area than the other first width (W1B), diameter, or area of the other first post 212b. In various cases, the first width (W1A) of the first post 212a, the other first width (W1B) of the other first post 212b, and the width (W1S) of a space 224 between the first post 212a and the second posts 212b combined into a combined width (W1C) are less than the second width (W2) of the second post 214.

In various embodiments, a third ratio ((W1A+W1B+W1S)/W2 or W1C/W2) between the combined first width ((W1A+W1B+W1S) or W1C) of the two or more first posts 212 plus the space 224 and the second width (W2) is less than or about equal to 0.642. By having the combined first width ((W1A+W1B+W1S) or W1C), diameter, or area be less than the second width (W2), diameter, or area, the chance of the one or more connections 400 (e.g., the one or more solder connections) cracking is reduced because the force of the two or more first posts 212 is distributed over the larger second post 214. Additionally, two or more first posts 212 can be provided on the second post 214 which increases the number of posts that can be used or the functionality within the semiconductor device 100.

FIGS. 5-8 illustrate different shapes of the one or more first posts 212 or second posts 214 that may be utilized in the semiconductor device 100, in accordance with one or more embodiments of the disclosure. These shapes are similar to the ones disclosed in United States Patent Number 11,723,143, which is hereby incorporated by reference in its entirety.

For example, as shown in FIGS. 5, the one or more first posts 212 or second posts 214 may be configured with a bar shape 502, a bent shape resembling a skew tetromino and having a general "Z" or "S" form 504, an "L" shape 506, a cruciform shape 508, a castle-wall or hollow block shape 510, and a block shape 512. The one or more first posts 212 or second posts 214 may include any other types of shapes, any combinations of shapes, or the like. Each of the shapes described above may have certain advantages. In a non-limiting example, bar shaped, bent shapes, or "L" shapes may be able to fit within one or more corners of the semiconductor device, castle-wall or hollow block shape 510 can be configured to surround one or more posts configured to transmit or receive one or more signals and provide radio frequency (RF) blocking, or the like, other shapes may be configured to fit around one or more dies, conductive layers, or the like of the semiconductor device. Additionally or alternatively, each of these shapes can include merged copper posts (e.g., two or more first posts 212 merged together or two or more second posts 214 merged together, or the like) which increases the ability of the merged posts in each of these shapes to block interfering RF signals (e.g., between signal pins, or the like) and dissipate heat from the semiconductor device.

In various cases, a first shape of the first post 212 can be configured as at least one of a bar shape, a bent shape, a Z shape, an S shape, an L shape, a cruciform shape, a hollow block shape, or a block shape, and a second shape of the second post can be a same shape as the first shape of the first post. However, the second shape of the second post 214 is configured to be larger (e.g., at least one of a larger width, larger diameter, larger length, or area, or the like) than the first shape of the first post 212. In some cases, the second post 214 can be configured as at least one of a bar shape, a bent shape, a Z shape, an S shape, an L shape, a cruciform shape, a hollow block shape, or a block shape and at least two first posts 212a and 212b can be coupled to one second post 214.

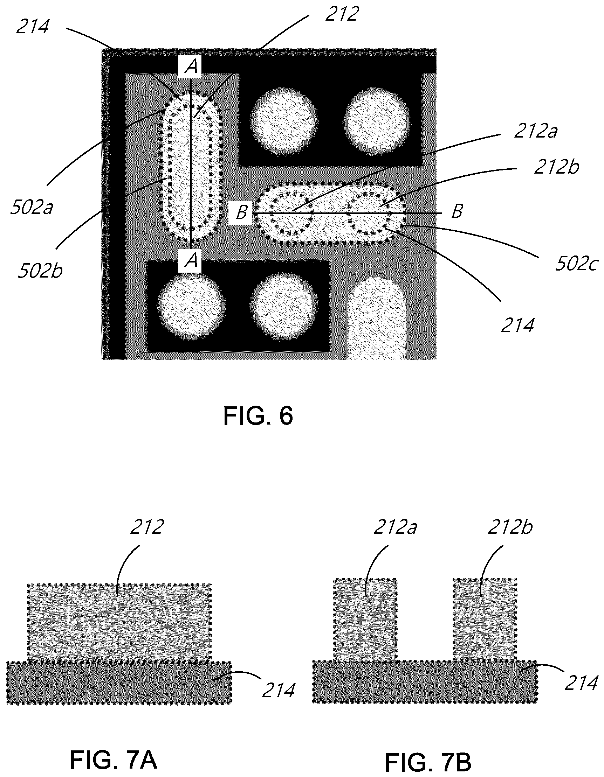

Turning to FIGS. 6 and 7, the second post 214 is configured as a bar shape 502a. In this scenario, the first post 212 coupled or connected to the second post 214 can mirror the shape of the second post and be a smaller bar shape 502b. However, in other cases, the second post 214 can be configured as a bar shape 502c while two or more first posts 212a and 212b are coupled or connected to the second post 214. In this scenario, the two or more first posts 212a and 212b can be any shape that is smaller than the shape of the second post 214.

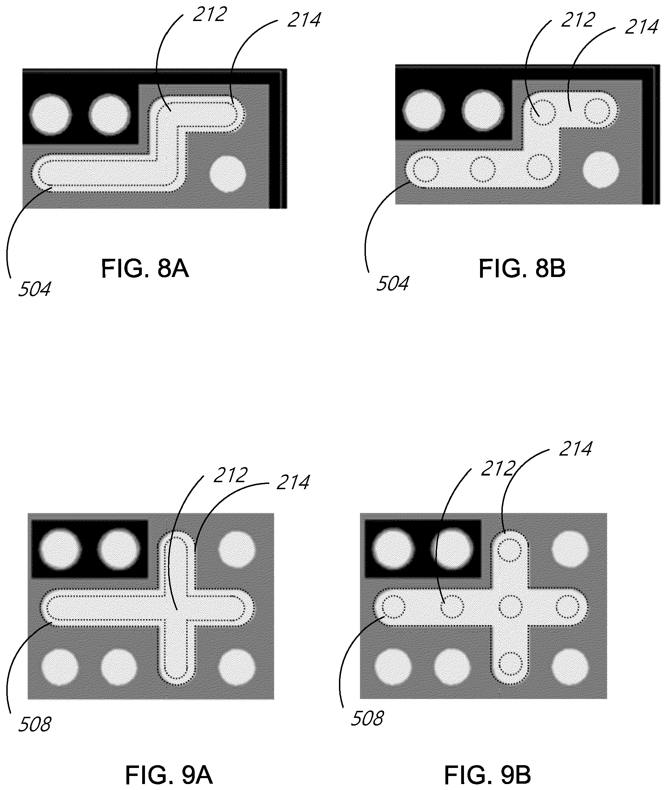

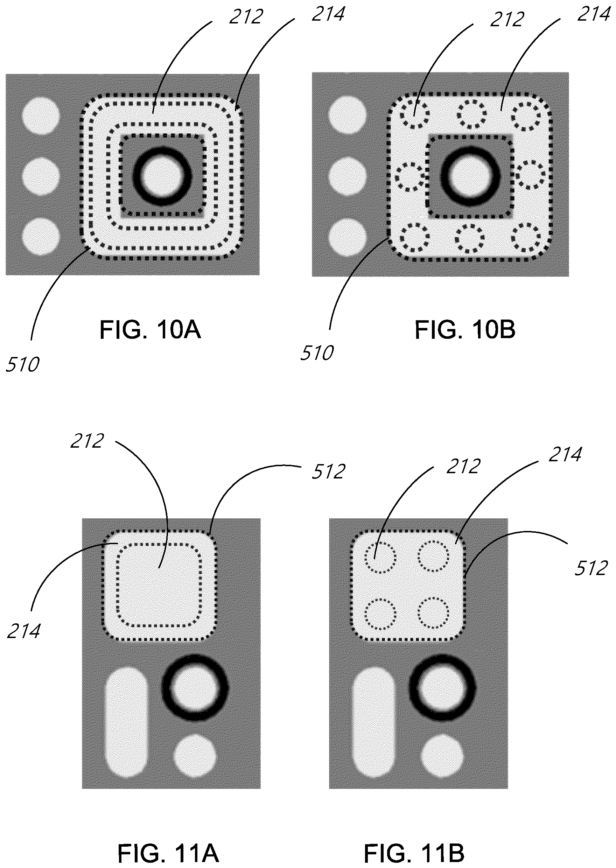

FIGS. 8-11 show different possible layouts of the one or more first posts 212 and the one or more second posts 214 when the one or more first posts 212 or the one or more second posts 214 are configured as different shapes such as those described above. However, the one or more first posts 212 and the one or more second posts 214 are not intended to be limited to only the layouts shown and other layouts are possible and within the scope of this disclosure.

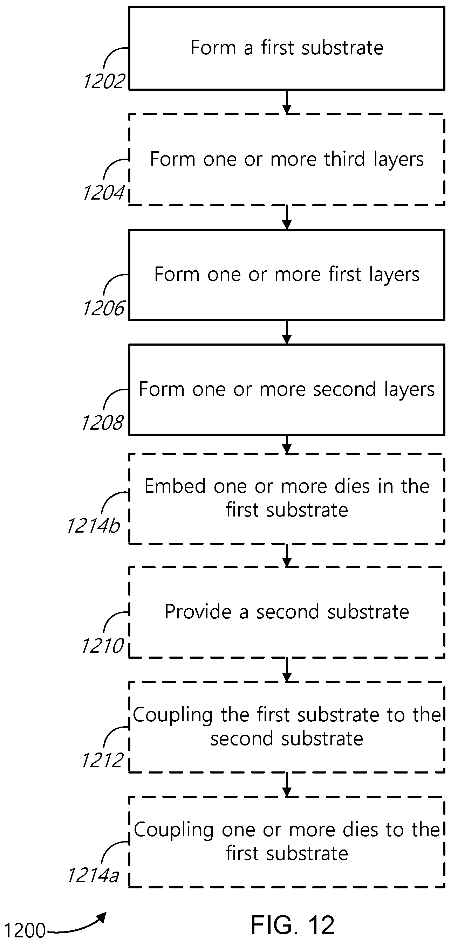

FIG. 12 is a flow diagram of a method of forming or manufacturing a semiconductor device (e.g., semiconductor device 100 or the like), in accordance with various embodiments. The method described in FIG. 12 is one way the components of FIGS. 1-11 can be formed or manufactured. However, other methods may be used to form or manufacture the components of FIGS. 1-11.

The method can begin at block 1202 by forming a first substrate (e.g., first substrate 200). The first substrate can include a circuit board or the like configured to couple to a second substrate such as a motherboard, or the like. In order to form the first substrate, one or more optional third layers (e.g., third layers 206 or the like) can be formed at optional block 1204.

Next, one or more first layers (e.g., first layers 202 or the like) can be formed or deposited on the one or more optional third layers at block 1206. Forming the one or more first layers can further include forming one or more first posts (e.g., first posts 212 or the like) within the one or more first layers. The one or more first posts can be formed using a variety of methods. In non-limiting examples, the formation of the one or more first posts can be performed by plating, chemical disposition, physical disposition, etching, or attachment or preformed metal posts, or the like. In some cases, the one or more first posts can be formed before the one or more first layers are formed. In other cases, the one or more first posts can be formed after the one or more first layers formed.

Next, one or more second layers (e.g., second layers 204 or the like) can be formed or deposited on the one or more first layers at block 1208. Forming the one or more second layers can further include forming one or more second posts (e.g., second posts 214 or the like) within the one or more second layers. The one or more second posts can be formed using a variety of methods. In non-limiting examples, the formation of the one or more second posts can be performed by plating, chemical disposition, physical disposition, etching, or attachment or preformed metal posts, or the like. In some cases, the one or more second posts can be formed before the one or more second layers are formed. In other cases, the one or more second posts can be formed after the one or more second layers formed.

In various cases, the one or more second posts can be coupled, either directly or indirectly, or connected, either directly or indirectly, to the one or more first posts. In some instances, a first width of the one or more first posts can be less than a second width of the one or more second posts. In some cases, at least two first posts can be coupled, either directly or indirectly, or connected, either directly or indirectly, to the one or more second posts.

In should be noted that, although the formation of the one or more layers of the first substrate are described in a particular order, the formation of the one or more layers could occur in any order during the fabrication of the first substrate. In a non-limiting example, the one or more first layers could be formed first, the one or more second layers could be formed first, the one or more third layers could be formed second, the one or more second layers could be formed second, or the one or more third layers could be formed third, or the like. In some cases, other layers other than the one or more first layers, second layers, or third layers could also be formed.

The method 1200 can then continue onto optional block 1210 and include providing or forming a second substrate (e.g., second substrate 300). The second substrate could be a motherboard, or the like. Next, at optional block 1212, the method 1200 can include coupling the first substrate to the first substrate via a solder connection. The solder connection can couple, either directly or indirectly, or connect, either directly or indirectly, the one or more second posts to one or more corresponding connectors (e.g., connectors 302 or the like) located on the second substrate.

The method 1200 can further include, at optional block 1214a, coupling one or more dies to a surface of the first substrate or, at optional block 1214b, embedding one or more dies during the formation of one or more layers (e.g., first layers, second layers, third layers, other layers, or the like) of the first substrate.

The techniques and processes described above with respect to various embodiments may be used to fabricate the semiconductor devices or components of FIGS. 1-11, and/or components thereof, as described herein.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. A system comprising:
a first substrate comprising:
a first layer comprising a first post having a first width; and
a second layer coupled to the first layer and comprising an outer surface of the first substrate and a second post having a second width connected to the first post, wherein the first width is less than the second width; and
a solder connected to the second post and configured to connect the second post to a first connector on a second substrate.

2. The system of claim 1, wherein the first substrate is a printed circuit board and wherein the second substrate is a motherboard, and wherein the solder connects the second post of the first substrate to the first connector on the second substrate
and/or
wherein the second width of the second post is about a same width as a corresponding third width of the first connector on the second substrate.

3. The system of claims 1 or 2, wherein a first ratio between the first width of the first post and the second width of the second post is less than or about equal to 0.375,
in particular,
wherein the first width of the first post is about 70 micrometers or less.

4. The system of one of the previous claims, wherein a first thickness of the first post is about a same thickness as a second thickness of the second post.

5. The system of one of the previous claims, wherein a second ratio between a first thickness of the first post and a second thickness of the second post is greater than or about equal to 1.28,
in particular,
wherein the first thickness of the first post is about 37 micrometers or more.

6. The system of one of the previous claims, wherein the first layer further comprises an other first post coupled to the second post,
in particular,
wherein a third width of the other first post is about a same width as the first width of the first post.

7. The system of claim 6, wherein the first width of the first post and a third width of the other first post combined are less than the second width of the second post.

8. The system of one of the previous claims, wherein a first shape of the first post is configured as at least one of a bar shape, a bent shape, a Z shape, an S shape, an L shape, a cruciform shape, a hollow block shape, or a block shape, and wherein a second shape of the second post is a same shape as the first shape of the first post.

9. The system of one of the previous claims, wherein the second post is configured as at least one of a bar shape, a bent shape, a Z shape, an S shape, an L shape, a cruciform shape, a hollow block shape, or a block shape and wherein the first layer further comprises an other first post coupled to the second post.

10. The system of one of the previous claims, further comprising:
a third layer coupled to the first layer opposite the second layer and comprising a first interconnect connected to the first post; and
a die coupled to the third layer opposite the first layer and comprising a second connector connected to the first interconnect.

11. A substrate comprising:
a first layer comprising a first post having a first width; and
a second layer comprising an external surface and a second post connected to the first post, the second post having a second width, wherein the first width is less than the second width, and wherein the external surface of the second layer is configured to couple to another substrate.

12. The substrate of claim 11, wherein a first ratio between the first width of the first post and the second width of the second post is less than or about equal to 0.375.

13. The substrate of claim 12, wherein the first width of the first post is about 70 micrometers or less,
in particular,
wherein a second ratio between a first thickness of the first post and a second thickness of the second post is greater than or about equal to 1.28.

14. A method of forming a forming one or more posts between a first substrate and a second substrate, the method comprising:
forming a first layer of the first substrate comprising a first post having a first width; and
forming a second layer on the first layer of the first substrate comprising a second post having a second width and connected to the first post, wherein the second layer is an outer layer of the first substrate, and wherein the first width is less than the second width.

15. The method of claim 14, further comprising:
forming a solder between the second post and a connector of the second substrate to connect the second post to the connector of the second substrate.
